(19) Europäisches Patentamt
European Patent Office
Office européen des brevets

(11) Publication number: 0 116 762 B1

# (12) EUROPEAN PATENT SPECIFICATION

(45) Date of publication of patent specification: **03.12.86**

(51) Int. Cl.[4]: **H 03 K 5/12,** G 11 C 5/06, G 11 C 11/40

(21) Application number: **83307504.7**

(22) Date of filing: **09.12.83**

## (54) Reforming digital signals in integrated circuits.

(30) Priority: **22.12.82 JP 233376/82**

(43) Date of publication of application: **29.08.84 Bulletin 84/35**

(45) Publication of the grant of the patent: **03.12.86 Bulletin 86/49**

(84) Designated Contracting States: **DE FR GB**

(56) References cited:
**US-A-3 989 955**
**US-A-4 338 678**

(73) Proprietor: **FUJITSU LIMITED
1015, Kamikodanaka Nakahara-ku
Kawasaki-shi Kanagawa 211 (JP)**

(72) Inventor: **Aoyama, Keizo c/o Fujitsu Limited
Patent Department 1015, Kamikodanaka
Nakahara-ku Kawasaki-shi Kanagawa 211 (JP)**

(74) Representative: **Sunderland, James Harry et al
HASELTINE LAKE & CO Hazlitt House
28 Southampton Buildings Chancery Lane
London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 116 762 B1

Courier Press, Leamington Spa, England.

**Description**

The present invention relates to the reforming of digital signals in integrated circuits. The invention is concerned with electronic circuits dealing with high speed digital signals and in particular with providing circuitry for reforming distorted digital signals in integrated circuit (IC) or a large scale integration (LSI) circuit.

Poly-silicon (polycrystalline silicon) layers are now being used for the internal wiring of a variety of semiconductor devices. For instance, word lines in static RAMs (Random Access Memories) are being formed of poly-silicon layers. The use of poly-silicon word lines eliminates the need for a double layer aluminium wiring line structure and allows the height to bumps formed at cross-over points where word lines cross bit lines — usually of aluminium — to be decreased. Step height differences at the bumps at such cross-over points can bring about problems such as reduced reliability and low manufacturing yield. Furthermore, when both word lines and bit lines are fabricated of aluminium, narrow margins for thermal treatment in manufacturing processes must be complied with. These problems increase the difficulties of device design, and decrease design freedom.

Poly-silicon is advantageous for forming wiring lines which are not required to have very low resistance, despite the fact that poly-silicon's conductivity is low when compared to that of aluminium, and this is why poly-silicon is being used for word lines of static RAMs for instance. Further benefits, such as simplification of manufacturing processes and improved manufacturing yield can also be provided by the use of poly-silicon wiring lines, because such lines can be formed together with other elements of an IC device in the general run of processes used for fabricating the devices in which they are used.

On the other hand, in order to avoid poly-silicon wiring lines of relatively high resistivity it is necessary to make the lines wide, but this increases the capacitance of the lines. Large line resistance and capacitance causes distortion of signals transmitted along a line, and an increased delay in the rise and/or fall time of the signals. This leads to logic speed decreases and increased operational error. For example, about 60 to 70 nanoseconds delay is inevitable in signals on poly-silicon word lines of a state-of-the-art 64-Kbit static RAM.

However, recent ICs or LSIs require delay times of 10 nanoseconds or less. Moreover, as the degree of integration increases, wiring lines become finer and longer. These facts make it difficult to use poly-silicon layer wiring lines in high integration applications.

One possible approach to a solution to this problem is to provide poly-silicon layers of lower resistivity. Using this approach, only a fifty percent reduction in terms of the delay time has been achieved. Another possible approach is to provide circuitry of a kind which cuts off the tail of delayed signals, by means of a gate attached at the end of each wiring line. This approach cannot improve rise time, is ineffective for longer wiring lines, and has the drawback of requiring clock measurements.

Consequently, a breakthrough is required to overcome the delay time problem of poly-silicon layer wiring in the increasing integration of ICs and LSIs.

EP—A1-0 019 241 discloses circuitry in accordance with the pre-characterising part of claim 1.

According to the present invention there is provided circuitry for reforming digital signals in an integrated circuit, comprising:

a positive feedback circuit, operable to detect commencement of the rise of a signal towards a high level, and/or the commencement of the fall of the signal towards a low level, and to feed a specific point of said integrated circuit with a potential substantially of the high level, when commencement of the rise is detected, and/or a potential substantially of the low level, when commencement of the fall is detected; characterised by

a positive feed feedback cut-off circuit, operable to detect completion of the rise, and/or completion of the fall, and upon such detection to terminate feeding of potential to the specific point by the positive feedback circuit.

An embodiment of the present invention can effectively reduce delay time which arises as a result of distortion of digital signals in large or long circuit networks.

An embodiment of the present invention can facilitate high speed operation of highly integrated semiconductor networks.

An embodiment of the present invention can serve to reduce operational error in highly integrated semiconductor networks.

An embodiment of the present invention can facilitate an increase in the integration density of ICs or LSIs.

Briefly, in an embodiment of the present invention circuitry for reforming distorted digital signals is attached to each of one or more specific points in a semiconductor network. The circuitry incorporates two essential functions: a function for feeding the specific point of the network to which it is attached with a power source potential (a HIGH or LOW signal potential, depending on whether signal rise or signal fall is involved) in response to detection of initiation of the rise or fall of an input signal; and a function for terminating the above-mentioned feeding of the potential in response to detection of completion of the rise or fall of the input signal. By these functions, the rising and falling portions of distorted digital signals are reformed.

Embodiments of the present invention can be employed in connection with poly-silicon wiring lines and also other lines, of other materials.

Reference is made, by way of example, to the accompanying drawings, in which:—

Fig. 1A schematically illustrates a prior art poly-silicon wiring line, for assistance in explaining the problem arising from its relatively high resistivity;

Fig. 1B is a waveform diagram illustrating signal waveforms arising at points marked "a" and "b" in Fig. 1A;

Fig. 2 is a schematic block diagram illustrating the operational principle of an embodiment of the present invention;

Fig. 3A is a schematic circuit diagram which illustrates an example of a positive feedback circuit and a positive feedback cut-off circuit employed in two embodiments of the present invention;

Fig. 3B is a waveform diagram illustrating signal waveforms arising at points marked "a", "b", "c", and "d" in Fig. 3A in an embodiment of the present invention in which both MOS (metal oxide semiconductor) transistors 302 and 304 are p-channel type transistors;

Fig. 3C is a waveform diagram illustrating signal waveforms arising at points marked "a", "b", "c" and "d" in Fig. 3A in an embodiment of the present invention in which both MOS transistors 302 and 304 are n-channel type transistors;

Fig. 4 is a schematic circuit diagram of a modified circuit configuration embodying the present invention;

Fig. 5A is a schematic circuit diagram of another modified circuit configuration embodying the present invention;

Fig. 5B is a waveform diagram illustrating signal waveforms arising at marked points "a", "b", "c", "c'", "d", and "d'" in Fig. 5A; and

Fig. 6 is a schematic circuit diagram of still another modified circuit configuration embodying the present invention.

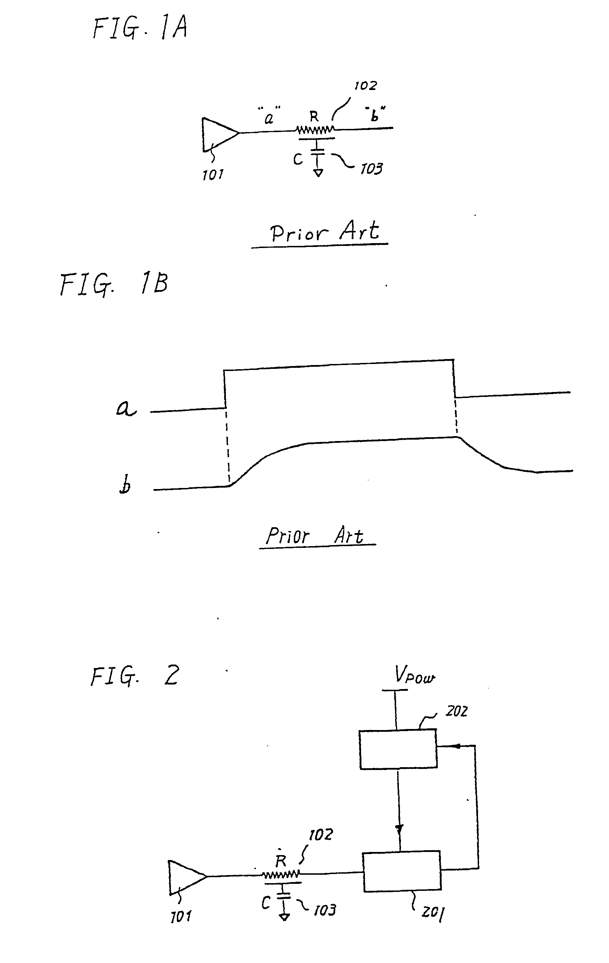

Fig. 1A schematically illustrates a prior art poly-silicon wiring line, and Fig. 1B illustrates signal waveforms occurring at points "a" and "b" marked in Fig. 1A.

A square wave digital signal (signal waveform a in Fig. 1B) is supplied to an input end "a" of the poly-silicon wiring line network of Fig. 1A from a signal source 101, a word line driver for example. The signal is distorted (as shown by signal waveform b in Fig. 1B) during its passage through a long poly-silicon wiring line, such as may be used in a static RAM for example. The poly-silicon wiring line can be considered as a distributed constant circuit consisting of a resistance 102 and a capacitance 103 as shown in Fig. 1A. The resistance 102 is inherent in the poly-silicon wiring line, whilst the capacitance 103 represents a total capacitance consisting of the capacities of components effectively connected to the poly-silicon wiring line, the capacity between the wiring line and a device substrate etc.

Fig. 2 is a schematic block diagram for assistance in explaining the operational principle of an embodiment of the present invention. In Fig. 2, 201 is a positive feedback circuit for detecting the initiation of the rise and/or fall of a digital signal at a point corresponding to the point marked "b" in Fig. 1A and for feeding that point with a selected voltage, for example a power source voltage $V_{pow}$. 202 is a positive feedback cut-off circuit for detecting the completion of the rise and/or fall of the digital signal and for cutting off the positive feedback provided by 201.

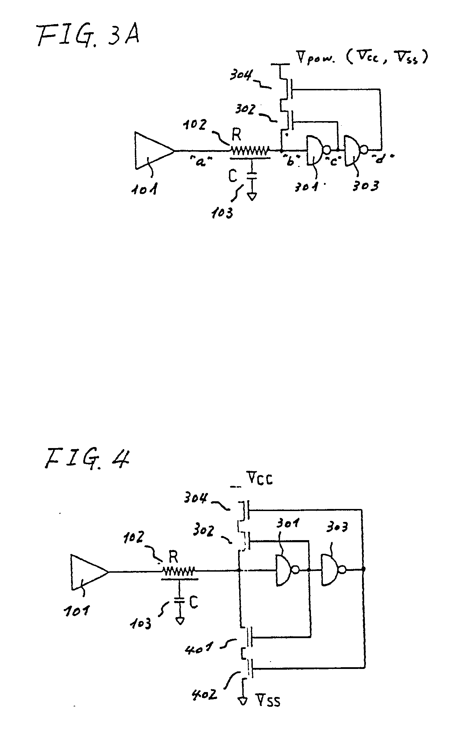

Fig. 3A illustrates exemplary configurations for a positive feedback circuit and a positive feedback cut-off circuit in embodiments of the present invention. The former comprises a first inverter 301 and a first MOS transistor 302. The latter comprises a second inverter 303 and a second MOS transistor 304. The first and second MOS transistors 302 and 304 and both p-channel type or both n-channel type, according to whether the rising portion of a signal or the falling portion of a signal is to be reformed. The transistors 302 and 304 are connected in series as shown in Fig. 3A.

Above, and in the following description, reference is made to MOS transistors for assistance in explaining circuits in accordance with embodiments of the present invention. However, it is to be understood that any transistors of the general MIS (Metal-Insulator-Semiconductor) type can be employed in embodiments of the present invention.

A description will now be given of a case in which the rising portion of a signal is to be reformed using circuits as shown in Fig. 3A. For this purpose, p-channel type MOS transistors are used for the first MOS transistor 302 and the second MOS transistor 304 is supplied with a positive voltage $V_{cc}$.

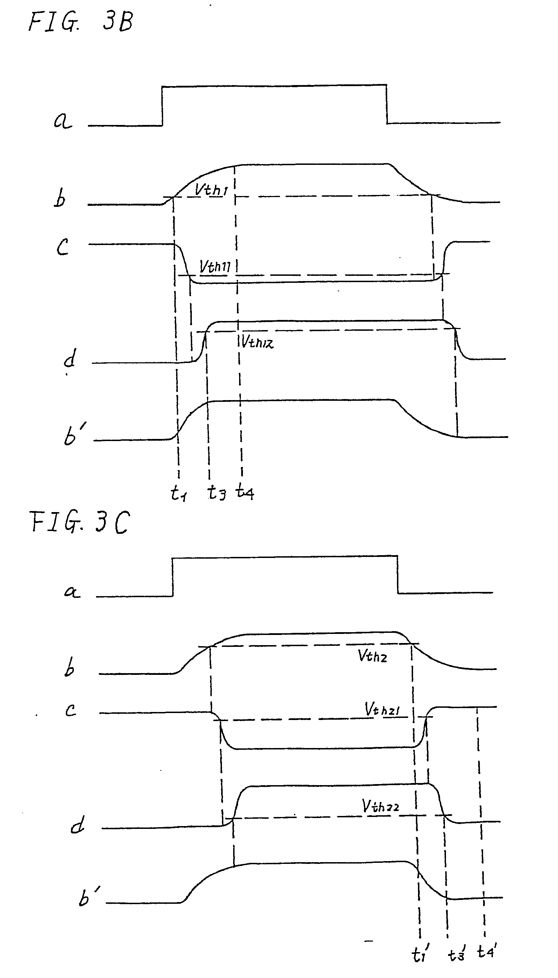

Referring to Fig. 3A and Fig. 3B, which is a waveform diagram showing waveforms a to d and b' relating to cirucit points "a" to "d" in Fig. 3A, when a distorted signal (waveform b) is input to first inverter 301, the output of the first inverter 301 (wavefrom c) turns to low level immediately after the input signal exceeds $V_{th1}$, the threshold level of the first inverter 301. In response to the input of a low level signal output from the first inverter 301, the first MOS transistor 302 turns to an ON state. At this moment, the second MOS transistor 304 is still in an ON state, because there is a short delay time before the output of the second inverter 303 switches to high level. Thus, both MOS transistors 302 and 304 are in the ON state, and the potential at the point "b" in Fig. 3A is rapidly pulled up towards power source voltage $V_{cc}$. When the output of the first inverter 301 reaches the threshold level $V_{th11}$, the threshold level of second inverter 303, the output voltage of the second inverter 303 (waveform d) starts to turn to high level. The second MOS transitor 304 turns to an OFF state as soon as the output of the second inverter 303 reaches a level $V_{th12}$, the point "b" in Fig. 3A is cut-off from the power source, and it retains the voltage $V_{cc}$. The level $V_{th12}$ is given by:—

$$V_{th12} = V_{cc} - V_{th(304)},$$

where $V_{cc}$ is power source voltage, and $V_{th(304)}$ is cut-off voltage of the second MOS transistor 304.

In the manner described above, potential at the point "b" in Fig. 3A is rapidly pulled up to a level just or almost equal to the power source voltage $V_{cc}$ which is equal to a HIGH level of the original signal output from the word line driver 101. The pull-up is performed in a short period of time, corresponding to the period from $t_1$ to $t_3$ in Fig. 3B. Rise time is thus reduced from time interval (t4 – t1) to the time interval (t3 – t1), and the distorted signal as shown by waveform b in Fig. 3B is reformed as waveform b' in Fig. 3B. As the point "b" is cut off from the power source after the potential reaches $V_{cc}$, subsequent potential fall at the point "b" is not prevented.

When a falling portion of a signal is received p-channel MOS transistor 302 turns to an OFF state, when the first inverter 301 detects that the signal becomes lower than threshold level $V_{th1}$. Accordingly, the point "b" is kept cut-off from the power source voltage, even when the p-channel MOS transistor 304 is turned to an ON state in response to a low level output of the second inverter 303. When provided with p-channel transistors 302 and 304 the circuit of Fig. 3A, therefore, does not operate in relation to a falling signal sequence, and in respect of the tail of falling portion of the signal a signal reforming function is not sufficiently provided.

Fig. 3C is a waveform diagram, similar to Fig. 3B, but concerned with the reformation of the falling portion of a signal. For this purpose, the first MOS transistor 302 and the second MOS transistor 304 in Fig. 3A are n-channel type transistors, and the source of the second MOS transistor 304 is supplied with negative voltage $V_{ss}$. Further, the first inverter 301 and the second inverter 303 are adjusted to have threshold levels $V_{th2}$ and $V_{th21}$ respectively as shown in Fig. 3C, different from the threshold levels of those inverters as shown in Fig. 3B.

Referring to Fig. 3A and 3C, the output of the first inverter 301 (waveform c) turns to high level immediately after the signal at the point "b" fails to reach (falls below) threshold level $V_{th2}$, then the first MOS transistor 302, being n-channel type, turns to an ON state. At this moment, the second MOS transistor 304, being n-channel type, is still in an ON state because output level of the first inverter 301 is not high enough to reach $V_{th21}$, the threshold level of the second inverter 303. Thus both MOS transistors 302 and 304 are in an ON state, and potential at the point "b" is rapidly pulled down towards the power source voltage $V_{ss}$. When output level of the first inverter 301 reaches the threshold level $V_{th21}$, the output level of the second inverter 303 (waveform d) starts to turn to low level. The second MOS transistor 304 turns to an OFF state as soon as output level of the second inverter 303 reaches threshold level $V_{th22}$. Accordingly, the point "b" is cut-off from the power source, and the feeding of voltage $V_{ss}$ to that point stops. The level $V_{th22}$ is given by the following equation,

$$V_{th22} = V_{th'(304)},$$

where, $V_{th'(304)}$, is the cut-off voltage of the n-channel type MOS transistor 304.

In the manner described above, potential at the point "b" is pulled down to a level just or almost equal to the source voltage $V_{ss}$, in a short period of time from $t_1'$ to $t_3'$ in Fig. 3C. The fall time is thus reduced from (t4' – t1') to (t3' – t1'), and the distorted signal shown by waveform b is reformed as shown by waveform b' in Fig. 3C.

With n-channel transistors 302 and 304, the circuit of Fig. 3A does not have a reforming function in respect to the rising sequence of a signal.

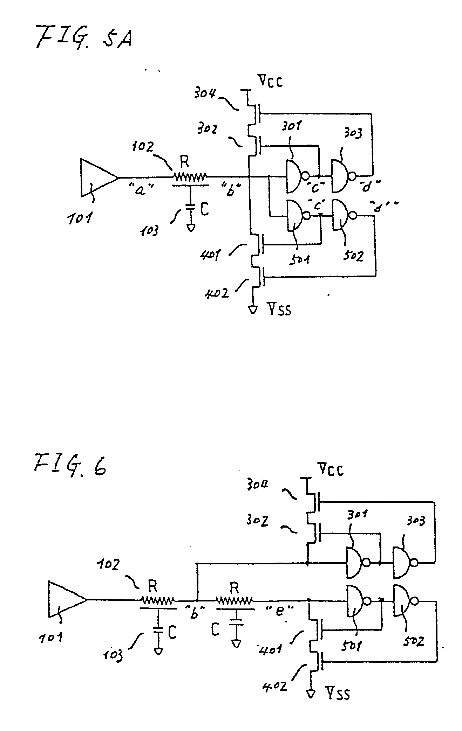

Figure 4 illustrates an embodiment of the present invention operable for reforming both rising and falling portions of a signal.

Referring to Fig. 4, first MOS transistor 302 and second MOS transistor 304 are p-channel type transistors, whilst third MOS transistor 401 and fourth MOS transistor 402 are n-channel type transistors. Transistors 302 and 304, and transistors 401 and 402 are connected in respective series, the source of the second MOS transistor 304 is supplied with a positive power source voltage $V_{cc}$, whilst the source of the fourth MOS transistor 402 is supplied with a negative power source voltage $V_{ss}$. $V_{cc}$ is equal to a HIGH level, and $V_{ss}$ is adjusted to be equal to a LOW level, of the original signal output from the word line driver 101. The MOS transistors 302 and 304 operate to reform the rising portion of the signal in the same manner as similarly numbered transistors as described in connection with Figs. 3A and 3B, and the MOS transistors 401 and 402 operate in the same manner as transistors 302 and 304 as described with reference to Figures 3A and 3C.

In the embodiment of Fig. 4, the timing for starting reforming of the rising portion and that for starting the reforming of the falling portion of the signal cannot be independent from each other (that is, rise time delay and fall time delay cannot be independently reduced), because the same inverter threshold voltages must serve for each purpose. A lower $V_{th1}$ is effective for reducing rise time delay, but it results in poor (relatively little reduced) fall time delay. On the other hand, a higher $V_{th1}$ is effective for reducing fall time delay, but it spoils the improvement in rise time delay. It is preferable to set $V_{th1}$ ( = $V_{th2}$) in the middle of the signal height, when both delay times are improved to the same degree.

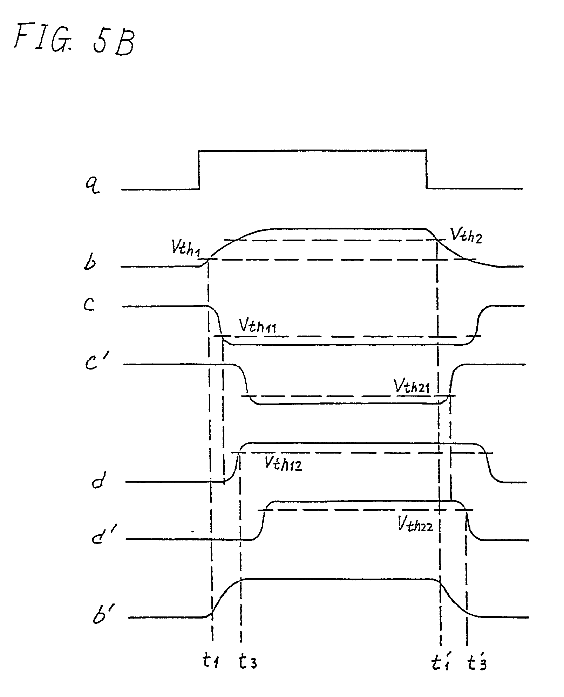

With reference to Figs. 5A and 5B a further embodiment of the present invention is described which enables independent timing selection for the reformation of both rising and falling portions of a signal. That is, rise time delay and fall time delay can be reduced individually as much as possible.

In Fig. 5A parts like or corresponding to parts in Fig. 4 are given the same reference numerals. Comparing Fig. 5A to Fig. 4, it will be seen that additional inverters 501 and 502 are included in Fig. 5A.

Fig. 5B shows waveform diagrams a to d and c', d' and b' relating to signals arising a circuit points labelled "a" to "d" and "c'" and "d'" in Fig. 5A.

It will be understood that in Fig. 5A the first MOS transistor 302, the second MOS transistor 304, the first inverter 301, and the second inverter 303 function to reform the rising portion of an input signal, whilst the third MOS transistor 401 and the fourth MOS transistor 402, with additional inverters 501 and 502, work to improve the falling portion of the input signal.

Threshold levels $V_{th1}$ and $V_{th2}$, (relating to inverters 301 and 303) and also $V_{th11}$ and $V_{th12}$ (relating to inverters 501 and 502) in Fig. 5B can be different from each other. This means that timings at which reformations start can be selected independently for the rising portion and for the falling portion of the input signal, and that a more precise delay time improvement can be effected.

In Fig. 5B, the waveforms a, b, and b' correspond to similarly labelled waveforms concerning previously described embodiments of the present invention and waveforms c, c', d, and d' show the changes of levels occurring at the points marked by "c", "c'", "d", and "d'" in Fig. 5A respectively.

In a manner similar to that described above, the potential at the point "b" is pulled up to a level just or almost equal to the source voltage $V_{cc}$ in a period from t1 to t3 in Fig. 5B. Further, the potential at point "b" is pulled down to level just or almost equal to the source voltage $V_{ss}$ in a period from $t_1'$ to $t_3'$ in Fig. 5B. $V_{cc}$ and $V_{ss}$ are adjusted to be equal respectively to HIGH level and LOW level of the original input signal. The distorted signal shown by waveform b is thus reformed as waveform b', in Fig. 5B.

A further embodiment of the present invention also enables independent timing selection in respect of the reformation of the rising portion and the falling portion of an input signal, as in the embodiment described with reference to Figures 5A and 5B. However, this further embodiment differs from that of Figures 5A and 5B in that reformation for the rising portion and reformation for the falling portion of an input signal are initiated at different points along a line. That, is, pull-up and pull-down of potential are effected at different points on the line.

Referring to Fig. 6, the first MOS transistor 302 and the second MOS transistor 304 are p-channel type transitors, and the source of the second MOS transistor 304 is supplied with a positive voltage $V_{cc}$, whilst the third MOS transistor 401 and the fourth MOS transistor 402 are n-channel type transitors, and the source of the fourth MOS transistor 402 is supplied with a negative voltage $V_{ss}$. The first inverter 301 and the source of the first MOS transistor 302 are connected to a point marked "b", whilst the third inverter 501 and the source of the third MOS transistor 401 are connected to a point marked "e". Therefore, potential at the point "b" is most markedly pulled up towards the voltage $V_{cc}$ during the rising sequence of the input signal, and potential at the point "e" is most markedly pulled down toward the voltage $V_{ss}$ during the falling sequence of the input signal. It will be clear that the points "b" and "e" are subject to a relatively weak pull-down effect and a relatively weak pull-up effect, respectively, by the potential change at the points "e" and "b" respectively. These weak pull-down and pull-up effects also contribute to a greater or a lesser degree to delay time reduction.

The configuration of the embodiment of Fig. 6 increases the freedom available for the physical design of circuit networks, because it alleviates need for concentration reforming circuit elements in a specified area. Moreover, delay time control can be effected as is most suitable according to short rise time or short fall time requirements, which differ point by point in a network.

With an embodiment of the present invention, rise and/or fall time of a reformed signal is altered in accordance with the threshold level of each inverter and MOS transistor therein, and is ultimately determined by the speed of the inverters and MOS transistors. In practice, a delay time of approximately 10 nonoseconds can be achieved by using the present invention on a poly-silicon wiring line whose RC time constant is equivalent to that of word lines of a state-of-the-art 64-Kbit static RAM, which lines previously had a delay time of approximately 70 nonoseconds.

Any number of circuits in accordance with embodiments of the present invention may be dispersedly attached to points on the wiring lines of large scale semiconductor networks in order to reform digital signals. By these means, such networks can avoid the limitations previously incurred when using poly-silicon wiring lines. Thus, difficulties in increasing integration density can be alleviated.

As the result of the achievement of reduced delay time for signals on poly-silicon layer wiring lines, embodiments of the present invention may facilitate higher operational speeds for highly integrated semicondutor networks, and also facilitate increased densities for ICs or LSIs, and reduced operational errors in highly integrated semiconductor networks. Thus, the present invention represents a significant breakthrough for surmounting disadvantages inherent in poly-silicon layer wiring. This means that the present invention may extend the possible scope of application of poly-silicon layer wiring.

Above, embodiments of the present invention have been described in the context of poly-silicon layer wiring. It will be appreciated, however, that the present invention can be applied to lines of other than poly-silicon for examples lines of a compound semiconductor such as gallium arsenide (GaAs) layers. Further any one of the described embodiments may be applied to a specific point of a wiring line in a semiconductor circuit network.

In summary, although it is desired to use poly-silicon layers for wiring lines in semiconductor devices, poly-silicon's relatively high resistivity is causing an obstacle to improvements in speed and/or integration density of the devices, because of signal distortion caused by the large time constant of poly-silicon wiring lines. This is true also of other wiring lines of materials of relatively high resistivity. Embodiments of this invention can provide for reduced rise and/or fall time delay of digital signals on poly-silicon layer wiring lines in static RAMs, for example, and also in wider range applications. Specific points of a network are fed with positive or negative voltage from power source immediately after the initiation of rise and/or fall of digital signals, and therefore the potential at the specific point is rapidly pulled up or pulled down toward the source voltage. Because the feeding of power source voltage is stopped when the potential reaches a specific value, the pull-up or pull-down does not prevent subsequent operations. Consequently, the signals are reformed to restore a square wave. The circuitry employed essentially consists of a positive feedback circuit and a positive feedback cut-off circuit, each of which can be constituted by an inverter and a MOS FET.

**Claims**

1. Circuitry for reforming digital signals in an integrated circuit, comprising:

a positive feedback circuit (201), operable to detect commencement of the rise of a signal towards a high level, and/or the commencement of the fall of the signal towards a low level, and to feed a specific point of said integrated circuit with a potential substantially of the high level, when commencement of the rise is detected, and/or a potential substantially of the low level, when commencement of the fall is detected; characterised by

a positive feedback cut-off circuit (202), operable to detect completion of the rise, and/or completion of the fall, and upon such detection to terminate feeding of potential to the specific point by the positive feedback circuit.

2. Circuitry as claimed in claim 1, wherein the positive feedback circuit comprises:—

a first inverter (301) the input terminal of which is connected to said specific point ("b"), to receive the said signal; and

a first MIS (Metal-Insulator-Semiconductor) transistor (302), the gate of which is conected to the output terminal of the first inverter (301), and the drain of which is connected to the said specific point ("b");

and wherein the positive feedback cut-off circuit comprises:—

a second inverter (303) the input terminal of which is connected to the output terminal of the first inverter (301); and

a second MIS transistor (304), the gate of which is connected to the output terminal of the second inverter (303), and the source of which is connected to a voltage supply line ($V_{pow}$) for providing a potential for feeding to the specific point ("b");

the first and second MIS transistors (302, 304) being serially connected between the said specific point ("b") and the voltage supply line ($V_{pow}$).

3. Circuitry as claimed in claim 2, wherein the first and second MIS transistors (302, 304) are p-channel type field effect transistors (FETs), and the source of the second MIS transistor (304) is connected to a high level (positive) voltage supply line ($V_{cc}$).

4. Circuitry as claimed in claim 2, wherein the first and second MIS transistors (302, 304) are n-channel type FETs, and the source of the second MIS transistor (304) is connected to a low level (negative) voltage supply line ($V_{ss}$).

5. Circuitry as claimed in claim 3, further comprising:

a third MIS transistor (401), being an n-channel type field effect transistor the gate of which is connected to the output terminal of the first inverter (301), and the drain of which is connected to the said specific point ("b"); and

a fourth MIS transistor (402), being an n-channel type field effect transistor, the gate of which is connected to the output terminal of the second inverter (303), the drain of which is connected to the source of the third MIS transistor (401) and the source of which is connected to a low level (negative) voltage supply line ($V_{ss}$).

6. Circuitry as claimed in claim 3 further comprising:

third and fourth n-channel type MIS transistors (401, 402), serially connected between the said specific point ("b") and a low level (negative) voltage supply line ($V_{ss}$);

a third inverter (501) the input terminal of which is connected to the said specific point ("b"), to receive the said signal; and

a fourth inverter (502) the input terminal of which is connected to the output terminal of the third inverter (501), the gates of the third and fourth MIS transistors (401, 402) being connected to the output terminals of the third and fourth inverters (501, 502) respectively, and the source of the fourth MIS transistor (402) being connected to the low level (negative) voltage supply line ($V_{ss}$).

7. Circuitry as claimed in claim 3, further comprising:

third and fourth n-channel type MIS transistors (401, 402), serially connected each between a further specific point ("e") of said integrated circuit and a low level (negative voltage supply line ($V_{ss}$); and

a third inverter (501) the input terminal of which is connected to the further specific point ("e"), to receive a signal therefrom,

a fourth inverter (502) the input terminal of which is connected to the output terminal of the third inverter (501), the gates of the third and fourth MIS transistors (401, 402) being connected to the output terminals of the third and fourth inverters (501, 502) respectively, and the source of the fourth MIS transistor (402) being connected to the low level (negative) voltage supply line ($V_{ss}$).

8. Circuitry as claimed in claim 3, 5, 6 or 7, wherein the high level (positive) voltage supply line is a positive power source voltage line ($V_{cc}$) of the integrated circuit.

9. Circuitry as claimed in claim 4, 5, 6 or 7 wherein the low level (negative) voltage supply line is a negative power source voltage line ($V_{ss}$) of the integrated circuit.

10. Circuitry as claimed in any preceding claim, wherein the said specific pont ("b"), and the said further specific point ("e") when provided, lies along a non-metallic wiring line of the integrated circuit, for example of poly-silicon or a compound semiconductor such as GaAs.

**Patentansprüche**

1. Schaltung zur Wiederherstellung digitaler Signale in einer integrierten Schaltung, mit:

einem Mitkopplungskreis (201), der im Betrieb den Beginn des Anstiegs eines Signals zu einem hohen Pegel und/oder den Beginn des Abfalls des Signals auf einen niedrigen Pegel detektiert und einem spezifischen Punkt der integrierten Schaltung ein Potential zuführt, das im wesentlichen einen hohen Pegel hat, wenn der Beginn des Anstiegs detektiert wird, und/oder ein Potential, das einen im wesentlichen niederigen Pegel hat, wenn der Beginn des Abfalls detektiert wird; gekennzeichnet durch

eine Mitkopplungs-Begrenzerschaltung (202), die betreibbar ist, um die Beendigung des Anstiegs und/oder die Beendigung des Abfalls zu detektieren und bei einer solchen Detektion die Zuführung des Potentials durch den Mitkopplungskreis an den spezifischen Punkt zu beenden.

2. Schaltung nach Anspruch 1, bei welcher der Mitkopplungskreis umfaßt:—

einen ersten Inverter (301), dessen Eingangsanschluß mit dem genannten spezifischen Punkt ("b") verbunden ist, um das genannte Signal zu empfangen; und

einen ersten MIS (Metall-Isolator-Halbleiter)-Transistor (302), dessen Gate mit dem Ausgangsanschluß des ersten Inverters (301) verbunden ist und dessen Drain mit dem spezifischen Punkt ("b") verbunden ist;

und bei welchem die Mitkopplungs-Begrenzerschaltung umfaßt:—

einen zweiten Inverter (303), dessen Eingangsanschluß mit dem Ausgangsanschluß des Inverters (301) verbunden ist; und

einen zweiten MIS-Transistor (304), dessen Gate mit dem Ausgangsanschluß des zweiten Inverters (303) verbunden ist und dessen Source mit einer Spannungsversorgungsleitung ($V_{pow}$) verbunden ist, zur Lieferung eines Potentials zur Speisung des spezifischen Punktes ("b");

wobei der erste und der zweite Transistor (302, 304), in Reihe zwischen dem genannten spezifischen Punkt ("b") und der Spannungsversorgungsleitung ($V_{pow}$) angeschlossen sind.

3. Schaltung nach Anspruch 2, bei welcher der erste und der zweite MIS-Transistor (302, 304) p-Kanal-Feldeffekttransistoren (FETs) sind, und die Source des zweiten MIS-Transistors (304) mit einer Hochpegel-(positiv)-Spannungs-versorgungsleitung ($V_{cc}$) verbunden ist.

4. Schaltung nach Anspruch 2, bei welcher der erste und der zweite MIS-Transistor (302, 304) n-Kanal-FETs sind und die Source des zweiten MIS-Transistors (304) mit einer Niedrigpegel-(negativ)-Spannungsversorgungsleitung ($V_{ss}$) verbunden ist.

5. Schaltung nach Anspruch 3, ferner mit:

einem dritten MIS-Transistor (401), der ein n-Kanal-Feldeffekttransistor ist, dessen Gate mit dem Ausgangsanschluß der ersten Inverters (301) verbunden ist, und dessen Drain mit dem genannten spezifischen Punkt ("b") verbunden ist; und

einen vierten MIS-Transistor (402), der ein n-Kanal-Feldeffekttransistor ist, dessen Gate mit dem Ausgangsanschluß des zweiten Inverters (303) verbunden ist, dessen Drain mit der Source des dritten MIS-Transistors (401) verbunden ist, und dessen Source mit einer Niedrigpegel(negativ)-Spannungsversorgungsleitung ($V_{ss}$) verbunden ist.

6. Schaltung nach Anspruch 3, ferner mit:

dritten und vierten n-Kanal-MIS-Transistoren (401, 402), die seriell zwischen dem genannten spezifischen Punkt ("b") und einer Niedrigpegel-(negativ)-Spannungsversorgungsleitung ($V_{ss}$) angeschlossen sind;

einem dritten Inverter (501), dessen Eingangsanschluß mit dem genannten spezifischen Punkt ("b") verbunden ist, um das genannte Signal zu empfangen; und

einem vierten Inveter (502), dessen Eingangsanschluß mit dem Ausgangsanschluß des dritten Inverters (501) verbunden ist, während die Gates des dritten und vierten MIS-Transistors (401, 402) mit den Ausgangsanschlüssen des dritten bzw. vierten Inverters (501, 502) verbunden sind, und die Source des vierten MIS-Transistors (402) mit der Niedrigpegel-(negativ)-Spannungs-versorgungsleitung ($V_{ss}$) verbunden ist.

7. Schaltung nach Anspruch 3, ferner mit:

dritten und vierten n-Kanal-MIS-Transistoren (401, 402), die seriell jeder zwischen einem weiteren spezifischen Punkt ("e") der genannten integrierten Schaltung und einer Niedrigpegel-(negativ)-Spannungsversorgungsleitung ($V_{ss}$) angeschlossen sind; und

einem dritten Inverter (501), dessen Eingangsanschluß mit dem weiteren spezifischen Punkt ("e") verbunden ist, um von diesem ein Signal zu empfangen,

einem vierten Inverter (502), dessen Eingangsanschluß mit dem Ausgangsanschluß des dritten Inverters (501) verbunden ist, während die Gates des dritten und vierten MIS-Transistors (401, 402) mit den Ausgangsanschlüssen des dritten bzw. vierten Inverters (501, 502) verbunden sind, und die Source des vierten MIS-Transistors (402) mit der Niedrigpegel-(negativ)-Spannungs-versorgungsleitung ($V_{ss}$) verbunden ist.

8. Schaltung nach Anspruch 3, 5, 6 oder 7, bei welcher die Hochpegel(positiv))-Spannungsversorgungsleitung eine positive Energiequellenspannungsleitung ($V_{cc}$) der integrierten Schaltung ist.

9. Schaltung nach Anspruch 4, 5, 6 oder 7, bei der die Niedrigpegel(negativ)-Spannungsversorgungsleitung eine negative Energiequellenspannungsleitung ($V_{ss}$) der integrierten Schaltung ist.

10. Schaltung nach einem der vorhergehenden Ansprüche, bei der der genannte spezifische Punkt ("b") und der genannte weitere spezifische Punkt ("e"), falls ein solcher vorgesehen ist, längs einer nichtmetallischen Verdrahtungsleitung der integrierten Schaltung angeordnet sind, z. B. aus Polysilizium- oder einem Verbindungshalbleiter wie GaAs.

**Revendications**

1. Circuit permettant de rétablir la forme de signaux numériques dans un circuit intégré, comprenant:

un circuit de réaction positive (201), ayant pour fonction de détecter le commencement de la montée d'un signal en direction d'un niveau haut et, ou bien, le commencement de la descente du signal vers un niveau bas, et d'alimenter un point spécifique dudit circuit intégré à l'aide d'un potentiel ayant sensiblement le niveau haut lorsque le commencement de la montée est détecté, et, ou bien, à l'aide d'un potentiel ayant sensiblement le niveau bas lorsque le commencement de la descente est détecté; caractérisé par:

un circuit (202) de coupure de réaction positive, ayant pour fonction de détecter la fin de la montée et, ou bien, la fin de la descente et, au moment de cette détection, de mettre fin à la délivrance du potentiel au point spécifique par le circuit de réaction positive.

2. Circuit selon la revendicaiton 1, où le circuit de réaction positive comprend:

un premier inverseur (301) dont la borne d'entrée est connectée audit point spécifique ("b") afin de recevoir ledit signal; et

un premier transistor MIS (métal-isolant-semiconducteur) (302), dont la grille est connectée à la borne de sortie du premier inverseur (301) et dont le drain est connecté audit point spécifique ("b");

et où le cirucit de coupure de réaction positive comprend:

un deuxième inverseur (303) dont la borne d'entrée est connectée à la borne de sortie du premier inverseur (301); et

un deuxième transistor MIS (304) dont la grille est connectée à la borne de sortie du deuxième inverseur (303) et dont la source est connectée à une ligne d'alimentation en tension ($V_{pow}$) servant à produire un potentiel d'alimentation du pont spécifique ("b");

les premier et deuxième transistors MIS (302, 304) étnat connectés en série entre ledit point spécifique ("b") et la ligne d'alimentation et tension ($V_{pow}$).

3. Circuit selon la revendication 2, où les premier et deuxième transistors MIS (302, 304) sont des transistors à effet de champ du type à canal p, et la source du deuxième transistor MIS (304) est connectée à une ligne d'alimentation en tension de niveau haut (positive) ($V_{cc}$).

4. Circuit selon la revendication 2, où les premier et deuxième transistors MIS (302, 304) sont des transistors à effet de champ du type à canal n, et la source du deuxième transistor MIS (304) est connectée à une ligne d'alimentation en tension de niveau bas (négative) ($V_{ss}$).

5. Circuit selon la revendication 3, comprenant en outre:

un troisième transistor MIS (401), qui est un transistor à effet de champ du type à canal n, dont la grille est connectée à la borne de sortie du premier inverseur (301) et dont le drain est connecté audit point spécifique ("b"); et

un quatrième transistor MIS (402), qui est un transistor à effet de champ du type à canal n, dont la grille est connectée à la borne de sortie du deuxième inverseur (303), dont le drain est connecté à la source du troisième transistor MIS (401) et sont la source est connectée à une ligne d'alimentation en tension de niveau bas (négative) ($V_{ss}$).

6. Circuit selon la revendicaiton 3, comprenant en outre:

un troisième et un quatrième transistor MIS du type à canal n (401, 402) connectés en série entre ledit point spécifique ("b") et une ligne d'alimenatation en tension d'un niveau bas (négative) ($V_{ss}$);

un troisième inverseur (501) dont la borne d'entrée est connectée audit point spécifique ("b") afin de recevoir ledit signal; et

un quatrième inverseur (502) dont la borne d'entrée est connectée à la borne de sortie du troisième inverseur (501), les grilles des troisième et quatrième transistors MIS (401, 402) étant respectivement connectées aux bornes de sortie des troisième et quatrième inverseurs (501, 502), et la source du quatrième transistor MIS (402) étant connectée à la ligne d'alimentation en tension de niveau bas (négative) ($V_{ss}$).

7. Circuit selon la revendication 3, comprenant en outre:

un troisième et un quatrième transistor MIS à canal n (401, 402) connectés en série chacun entre en autre point spécifique ("e") dudit circuit intégré et une ligne d'alimentation en tension de niveau bas (négative) ($V_{ss}$); et

un troisième inverseur (501) dont la borne d'entrée est connectée à l'autre point spécifique ("e") afin de recevoir un signal de celui-ci,

un quatrième inverseur (502) dont la borne d'entrée est connectée à la borne de sortie du troisième inverseur (501), les grilles des troisième et quatrième transistors MIS (401, 402) étant respectivement connectées aux bornes de sortie des troisième et quatrième inverseurs (501, 502), et la source du quatrième transistor MIS (402) étant connectée à la ligne d'alimentation en tension de niveau bas (négative) ($V_{ss}$).

8. Circuit selon la revendication 3, 5, 6 ou 7, où la ligne d'alimentation en tension de niveau haut (positive) est une ligne de tension de source d'alimentation électrique positive ($V_{cc}$) du circuit intégré.

9. Circuit selon la revendication 4, 5, 6 ou 7, où la ligne d'alimentation en tension de niveau bas (négative) est une ligne de tension de source d'alimentation électrique négative ($V_{ss}$) du circuit intégré.

10. Circuit selon l'une quelconque des revendications précédentes, où ledit point spécifique ("b"), ainsi que ledit autre point spécifique ("e") lorsqu'il est prévu, se trouve le long d'une ligne de câblage non métallique du circuit intégré, par exemple en silicium polycristallin ou en semi-conducteur composé comme GaAs.

FIG. 1A

102
"a"
R
"b"
C
103
101

Prior Art

FIG. 1B

a
b

Prior Art

FIG. 2

VPOW
202
102
R
C
103
101
201

FIG. 3A
Vpow. (Vcc, Vss)
304
302
102
R
"a"
"b"
"c"
"d"
C
101
103
301
303

FIG. 4
Vcc
304
302
301
303
102
R
C
101
103
401
402
Vss

FIG. 3B

a
b
Vth1
c
Vth11
Vth12
d
b′
t1
t3
t4

FIG. 3C

a
b
Vth2
c
Vth21
Vth22
d
b′
t1′
t3′
t4′

FIG. 5A

Vcc
304
302
301
303
102
R
"a"
"b"
"c"
"d"
"c'"
"d'"
C
101
103
401
501
502
402
Vss

FIG. 6

Vcc
304
302
301
303
102
R
R
"b"
"e"
C
C
101
103
401
501
502
402
Vss

FIG. 5B

a
b
Vth1
Vth2
c
Vth11
c'
Vth21
d
Vth12
d'
Vth22
b'
t1
t3
t1'
t3'